(19) Europäisches Patentamt
European Patent Office
Office européen des brevets

(11) **EP 1 418 437 A1**

(12) **EUROPEAN PATENT APPLICATION**

(43) Date of publication:
**12.05.2004 Bulletin 2004/20**

(51) Int Cl.⁷: **G01R 31/06**, G01R 31/34

(21) Application number: **03103659.3**

(22) Date of filing: **02.10.2003**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK**<br><br>(30) Priority: **02.10.2002 EP 02405849** | (71) Applicant: **ALSTOM Technology Ltd**<br>**5400 Baden (CH)**<br><br>(72) Inventors:<br>• **Rabach, Germano**<br>**34016, Trieste (IT)**<br>• **Visintin, Massimiliano**<br>**8046, Zürich (CH)** |

(54) **Method and electromagnetic sensor for measuring partial discharges in windings of electrical devices**

(57)   A method for measuring partial discharges in windings of electrical devices comprised by the following steps: Applying voltages having high frequency components to the winding of the electrical device, detecting partial discharge signals by means of a tuned VHF and/or UHF electromagnetic sensor located close to the electrical device and evaluating the detected sensor signals by means of electrical hardware or software. Further, a VHF and/or UHF electromagnetic sensor for measuring partial discharges in windings of electrical devices is described wherein an antenna made of a coaxial cable is provided as electromagnetic sensor. The present invention provides an improved measuring method and sensor device, which avoid the drawbacks of the prior art. The improved measuring method provides more detailed information about the status of the insulation system and clear short-circuits during the testing are not necessary any more. The proposed sensor provides a surprisingly simple and inexpensive solution.

Fig.1

EP 1 418 437 A1

## Description

## Technical Field

The invention refers to a method and an electromagnetic sensor for measuring partial discharges (PD) in windings of electrical devices, e.g. electrical generators and motors, particularly in stators and/or rotors, stressed by voltage sources having high frequency (surge) components.

## Related Prior Art

Methods and sensors for measuring partial discharges in windings of electrical devices, e.g. Ac or Dc electrical generators and motors, are already known in the prior art. These devices are generally fed by power networks at industrial frequencies of either 50 or 60 Hz. Currently both, couplers and electromagnetic sensors available on the market, are broadly used for partial discharge measurements. These measuring devices are either capacitors appropriately placed within the electric machine or outwardly. In addition, in some cases high frequency sensors are located in the stator slots.

Partial discharges, that can lead to breakdowns in the insulating system, are caused by high internal stresses, mainly induced by 50 / 60 Hz voltages, as well as by high frequency electromagnetic fields due to lightning pulses, connection transients etc. Generally, these impulsive stresses are not uniformly distributed along the stator winding, but are located within the first turns connected to the high-voltage source, so they can principally induce failures in the turn and / or conductor insulation of the winding, that may lead then to the ground insulation yielding. These damages induced by such impulsive stresses are even more severe if frequency converters are interposed between the electrical machine and the network, in particular if pulse width modulated (PWM) inverter fed motors are considered.

A discharge inception is generally bound to the characteristics of the dielectric materials and to the whole insulation system, as well as to the employed manufacturing technology. For measuring the turn and / or conductor insulation integrity and their limits, present off-line techniques apply voltage pulses to the winding by means of a so-called surge tester. These instruments compare the low frequency responses of two coils or two groups of coils belonging to the same winding. Often the applied surge voltages cause damages in some insulation areas owing to the low sensitivity of this technique. Therefore, relatively big pulses are needed that stress gratuitously the dielectric and accelerate in any case the aging. There are even more disadvantages in that method used up to now, as e.g. the need to induce a clear short-circuit, and the lack of measuring a value related to the condition of the turn or conductor insulation of the respective winding.

Campbell et al. describe in "Practical On-line Discharge Tests for Turbine Generators and Motors", IEEE Transactions on Energy Conversion, Vol. 9, No.2, June 1994, pp.281 -287, an on-line partial discharge test under 50 / 60 Hz stresses only using high voltage bus couplers or using stator slot couplers (SSC). The former consist of high voltage capacitors which are connected to the machine terminals, the latter are ultra wide band detectors installed under a few stator wedges closing the slots containing the stator bars. An instrument for converting the pulses from each coupler to digital form is part of the test arrangement. By means of differential measurements, noise signals coming from outside can be recognized.

Further, Stone et al. describe in "New Tools to Determine the Vulnerability of Stator Windings to Voltage Surges from IFDs", Proc. IEEE Electrical Conference, Cincinnati, October 1999, pp. 149-153, a partial discharge measuring system for measuring partial discharge pulses that occur during steep fronted voltage surges from Invertor Fed Drives (IFDs). For this test arrangement, a device is used that attenuates the surge voltage more than 10000 times (80 db), while leaving the partial discharge pulses essentially unchanged.

Major drawbacks of the known measuring techniques are that they do not provide an absolute measurement, i.e. they only allow damage recognition by means of a comparative method and therefore can not be used if only one probe is available at a time. Further, the known measuring techniques provide only information on the presence of possible short-circuits in the turn/conductor insulation if the voltage level during the test is high enough to induce a clear short-circuit. Another important drawback is the fact that the present measuring techniques can only be used during production, as a quality test, but give only passed/non-passed type results. This does not provide any parametric indication, e.g. a value of the turn/conductor insulation condition, on which an assessment of further actions to improve the winding insulation can be based. Consequently, the present measuring techniques may require relatively high voltage pulses which may induce insulation damages not present before the test and in general will cause accelerated aging of the insulation. Further, the present measuring techniques do not provide any indication about incipient damages or the general condition of the turn/conductor insulation. Finally, the presently known methods do not provide any means to locate the damage because the short-circuits can only be clearly seen if the surge tester power is high enough to "burn" the insulation surrounding the discharge site.

There have been some efforts in the prior art to overcome these drawbacks.

DE 299 12 212 U1 discloses a device for measuring partial discharge in electrical machines or devices using a ring sensor placed around the machine's main cables. However, since the high frequency discharge signals are rapidly damped as they travel apart from the discharge site, using the sensor arrangement according to DE 299 12 212 U1 leads to detection difficulties, e.g. noise, signal distortion, too smooth signal, etc. The signal will be damped very strongly and reflections of the discharge signal happen because of different impedance characteristics of the machine winding and the main cables. Further, with the sensor arrangement according to DE 299 12 212 U1 the precise position of the discharge site can not be localized.

WO 94/07152 discloses a method for measuring partial discharge in an electrical machine by using at least one temperature sensor placed at the machine winding. According to this disclosure the high frequency discharge signal is measured by using the temperature sensor as an antenna and if more than one temperature sensors are used the position of the discharge location can be localized. However, a temperature sensor is only similar to an antenna, because it has straight cables laid down on an insulation support, but they are connected to a resistor, e.g. a Pt 100, or to a thermocouple. This causes unwanted coupling to low frequency signals, noise or signals induced by the surge tester itself. Further, temperature sensors are inserted only in some stator slots and therefore, in case a discharge signal happens far away from the detection area, no signal can be recognized as corresponding to a particular discharge.

**Disclosure of the Invention**

Therefore, it is an object of the present invention to provide an improved measuring method, which avoids the stated drawbacks of the prior art. The improved measuring method should provide more information about the status of the insulation system by using non-destructive techniques. If a surge voltage is applied it should be similar or even lower than the actual operation voltage of the electric machine. Clear short-circuits should be avoided. The sensor equipment should be simple, available in a greater number and at reasonable costs.

This object is solved by a method for measuring partial discharges in windings of electrical devices having the features of claim 1 and an electromagnetic sensor for measuring partial discharges in windings of electrical devices having the features of claim 11. Preferred embodiments of the present invention are described in the dependent claims.

The present invention provides an improved measuring method which avoids the drawbacks of the prior art and which provides more detailed information about the status of the insulation system by using non-destructive techniques. Clear short-circuits during testing are not necessary any more. The electromagnetic sensor according to the present invention is surprisingly simple, available in a greater number and at reasonable costs.

The method for measuring partial discharges in windings of electrical devices according to the present invention is comprised of the following steps:

- Applying voltages having high frequency (surge) components to the winding of the electrical device;
- Detecting partial discharge signals by means of a plurality of tuned VHF and/or UHF electromagnetic sensors being arranged at a plurality of freely chosen positions close to the electrical device to determine the position of the discharge location; or
- Detecting partial discharge signals by means of one tuned VHF and/or UHF electromagnetic sensors being sequentially arranged at a plurality of freely chosen positions close to the electrical device to determine the position of the discharge location; and
- Evaluating the detected sensor signals by means of electrical hardware and/or software.

The present invention comprises a method for measuring partial discharges, for example in stator windings of electrical machines or in Roebel bars of turbogenerators, which uses VHF and/or UHF electromagnetic couplers, in particular in the GHz range, for measuring the discharge signals and for attenuating unimportant signals. By means of the proposed technique the partial discharge inception voltage can be measured under surge voltage stresses and at the same time all the general characteristics of the discharge patterns can be obtained, e.g. their distribution or the highest discharge patterns. Moreover, using the inventive method, the stator discharges can be clearly distinguished from other disturbing error signals. Indeed, the inception and/or extinction voltage is an important parameter, which allows an evaluation of the quality of the insulation system. The detected inception voltage can then be compared to the highest levels of the surge voltages that can be present during the machine service; the levels can be either measured in actual conditions or computed. The measurement is performed without any electrical connection between the sensor and the sample under test, thus being a safe procedure. The measurement can be run during the manufacturing process or in the quality control tests or during normal operation, when high frequency components are present in the voltage/current source (for example during frequency converter feedings). One major advantage of the inventive method is the fact that the sensors can be positioned close to the discharge location and therefore the high frequency discharge signals can be better detected. This is due to the fact that the higher the frequency the higher the damping factor and hence the closer the sensor is located at the discharge site the better the detected signal. According to the one alternative of the method, with a generator length exceeding two meters at least one sensor per stator bar is recommended. The sensor can for example either be directly attached to the stator bars or placed in a range of 1 cm to 10 cm away from the stator bars.

A preferred embodiment of the method according to the present invention comprises that a suitable surge test pulse voltage is applied to the windings of the electrical device. However, as mentioned before, this is not an exclusive requirement since the measurement can also be executed under normal operation conditions with operation voltages having high frequency components, i.e. surges.

Another preferred embodiment of the method according to the present invention comprises that that the plurality of sensors comprises at least one sensor per electrical phase should be provided, i.e. at least three sensors are advantageous. In this case the sensor advantageously can be positioned close to the phase which is connected to the high voltage. The first experimental results on motor windings showed that different signal shapes could be detected, depending on the distance between the sensor position and the discharge site. For example, the detection of an "unipolar" discharge signal can infer that the discharge area is very near to the acquisition location, because the discharge is picked up before any signal reflection. On the contrary, an "oscillating" signal can be considered as an indicator of a partial discharge located quite far away from the sensor site. Discharge locations may be simply retrieved if several sensors are used.

Further, a preferred embodiment of the method according to the present invention comprises that the applied voltage is a high frequency Ac or a Dc voltage or a frequency converter output. In the case of a Dc voltage, an induced surge pulse is preferable to gain best measurement results.

Still another preferred embodiment of the method according to the present invention comprises that a surge test voltage having a variable pulse is applied wherein the repetition rates are different from 50/60 Hz. Thus, the test results can be clearly distinguished from power supply signals and test frequencies.

Another preferred embodiment of the method according to the present invention comprises that the detected sensor signals are filtered by a conditioning circuit. Alternatively the detected sensor signals are filtered by a software filter, e.g. based on the Fast Fourier Transformation (FFT). The discharge patterns can then be quantitatively analyzed through stochastic analyses.

Another preferred embodiment of the method according to the present invention comprises that the sensor is located near the coils connected to the high voltage source since this will generally provide the strongest signals.

Another preferred embodiment of the method according to the present invention comprises that at least two high frequency sensors are placed close to the machine's high voltage terminal and to the low voltage one respectively, to reject noise signals and / or to infer the discharge position along the winding by means of a differential measuring mode.

The proposed measuring methodology is considerably different from the techniques presently used in case of surge voltages. In particular, the use of very high-frequency electromagnetic couplers is now proposed, in order to measure the discharge signals, as well as to attenuate those unimportant as much as possible. The signals associated to partial discharges are known to have less than 10 ns rise times, whereas for example the pulse trains sent by pulse width modulated inverters generally have hundreds of nanoseconds (ns) rise times, if measured at the electric machine terminals. Therefore, to discriminate efficaciously the discharge signals from those induced by the surge testers, the coupling sensor has frequency characteristics capable of attenuating the latter, keeping unaltered the former, or at least as much as possible. If pulse-width-modulation-like voltages are used, it has been experimentally proven that the sensor meets such requirements, if it has a bandwidth centered around some GHz. By applying the measurement method according to the present invention, a good discrimination can be obtained between discharge signals and those induced by the feeding itself. Other frequency ranges may be necessary if partial discharge measurements are to be carried out using different voltage shapes. Furthermore, this approach also allows the detection of partial discharges that happen during the rise front of the test pulse.

Only the discharge signals can finally be obtained if a proper conditioning circuitry is used, that further filters the measured pulses, thus attenuating the test pulse. Otherwise such a signal conditioning can be obtained by means of dedicated software, based for example on the Fast Fourier Transform (FFT), capable of pointing out only the frequency components related to the discharge signal. Whatever conditioning is chosen, the discharge signals can be processed afterwards, so as to study the amplitude distribution patterns, for example, by means of electronic equipment already developed and available on the market. This post-processing feature seems to be quite necessary in such measurements because the test voltage is generally slightly above the inception level only, thus the discharge does not happen at every pulse. In such conditions, acquisition time intervals should be relatively large, if compared to the duration of each pulse, to show the presence of partial discharge phenomena. Therefore a stochastic analysis seems to be necessary to characterize the discharge patterns both quantitatively and qualitatively. The statistic feature of the partial discharge events is further enhanced, whether possible surge test variations take place, and must be taken into account, due to the unsteadiness of the generated surges at the machine's terminals.

An antenna obtained from a coaxial cable (for example a BNC cable) is provided as VHF and / or UHF electromagnetic sensor for measuring partial discharges in windings of electrical devices according to the present invention.

In a preferred embodiment of the electromagnetic sensor according to the present invention the tuned frequency of the antenna is selected according to the signal range of interest, in particular in the GHz range. To that purpose the inner conductor of the coaxial cable piece is laid free in a length of ¼ wavelength according to the frequency or frequency band wished to receive. The outer conductor can also be laid free.

In still another advantageous embodiment of the electromagnetic sensor, according to the present invention, the length of the antenna is 25 mm for a tuned frequency of 3 GHz. This is a typical application of the present invention, however the given values can vary from case to case.

Considering the frequency range involved, the proposed sensor is very selective which means that partial discharges can be detected only if they are located close to the sensor. As a consequence, these antennae are to be located where the discharge probability is relatively high, i.e. near the coils heavily stressed by electric fields, in other words near to those connected to the high voltage source. Indeed, this is not a restriction, due to the low cost of the antenna. Many of such sensors could be simply employed during any measurement, which also has the effect that the position of the discharge can be inferred rather exactly.

The possible discharge sites are the ground insulation and the inter-turn insulation, both in the slot area and in the end-winding region. If randomly wound motors are under consideration, for example vacuum pressure impregnated ones (VPI), it can be pointed out that a good resin refilling is usually reached in the slots, obtaining in such an area a low partial discharge inception probability, provided that the manufacturing process is properly carried out. On the contrary, especially in case of the vacuum pressure impregnated machines, the end-winding conditions are more uncertain due to air gaps between the coil turns which may lead locally to very high voltage gradients. As a matter of fact, the experience shows that surge voltages induce, in many cases, breakdowns exactly in the winding overhangs where, in addition to some boundary effects of the electric field, the manufacturing process may lead to some resin lacks within the coils and causes some local damage of the insulation of the turns due to coil settlement in the stator and their mechanical adaptation.

## Brief Description of the Drawings

Following, the present invention will be described in further detail in connection with the attached drawings, wherein

Fig. 1    shows a schematic view of an antenna sensor according to a preferred embodiment of the present invention;

Fig. 2    shows an output signal of the antenna sensor according to figure 1 when placed near the first coil of a cross wire stator winding in a random wound motor;

Fig. 3    shows a surge test voltage when applied between the motor terminal of one phase;

Fig. 4    shows a partial discharge signal waveform obtained by an antenna sensor; and

Fig. 5    shows a surge test voltage and the output signal from the antenna sensor according to figure 1.

## Preferred Embodiments

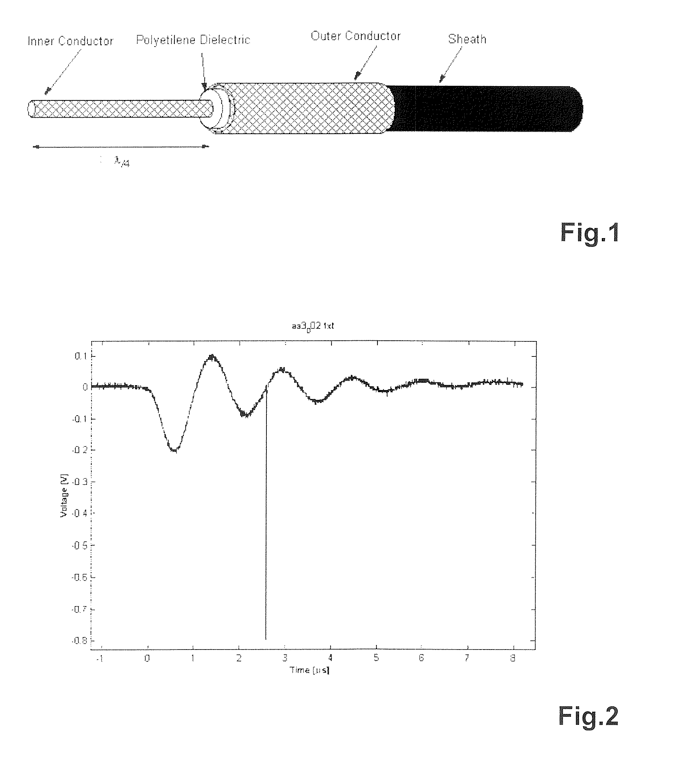

One preferred embodiment of the electromagnetic sensor according to the present invention is schematically shown in figure 1. According to this embodiment, the electromagnetic sensor is obtained from an usual BNC coaxial cable, the latter consists of an inner conductor which is surrounded by a polyethylene dielectric which is entirely surrounded by a sheath material. The sheath material is surrounded by an outer conductor and coated with a (non shown) tube material, e.g. polyvinylchloride. To get the electromagnetic sensor according to the preferred embodiment of the present invention, as sketched in Fig. 1, the inner conductor is freed for a defined length l and the outer conductor can be cut off or simply turned inside out and stuck on the protective tube of the BNC cable. The free length of the inner conductor is directly related to the tuned frequency to be measured and can be calculated according to the formula:

$$l = \lambda/4.$$

wherein l = length of the freed inner conductor and $\lambda$ = wavelength of the tuned frequency to be measured.

It has been experimentally proven that an antenna sensor, obtained from a simple coaxial cable as shown in figure 1, is suitable to be used as a very high frequency electromagnetic coupler. This antenna sensor can be produced at low costs and in a large quantity.

Figure 2 shows the signal that has been picked up with the proposed sensor from a random wound motor winding. In the diagram of figure 2, the following units are shown: X-axis time in µs, Y-axis Voltage in V. The antenna of figure 1 has been used as electromagnetic sensor. The antenna has been located near the first coil of a cross wire stator winding in a random wound motor, stressed by a steep fronted pulse. The antenna was 25 mm long for a tuned frequency of 3 GHz. The impulsive source produced a signal which reflects a damped vibration wave having an amplitude of 0,2 V, while the partial discharge induced a superimposed higher frequency signal, whose amplitude was 0,8 V, much bigger than the damped signal due to the impulsive source, so the discharge signal could be simply recognized.

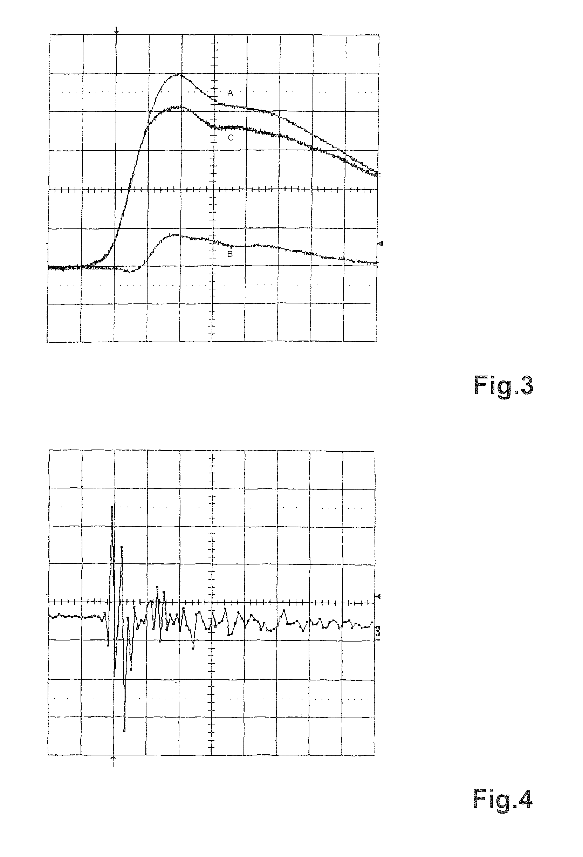

Figure 3 shows the surge test voltage applied between the motor terminal of one phase (curve C). In the diagram of figure 3 the following units are shown: X-axis 500 ns/div; Y-axis 500 V/div. In this example the surge voltage had a rise time of approximately 700 Nano Seconds (ns). This waveform could be simply obtained through a differential measuring mode, by means of two wide frequency-band high voltage probes connected respectively to the motor high voltage terminal (curve A), and to the low voltage one (curve B).

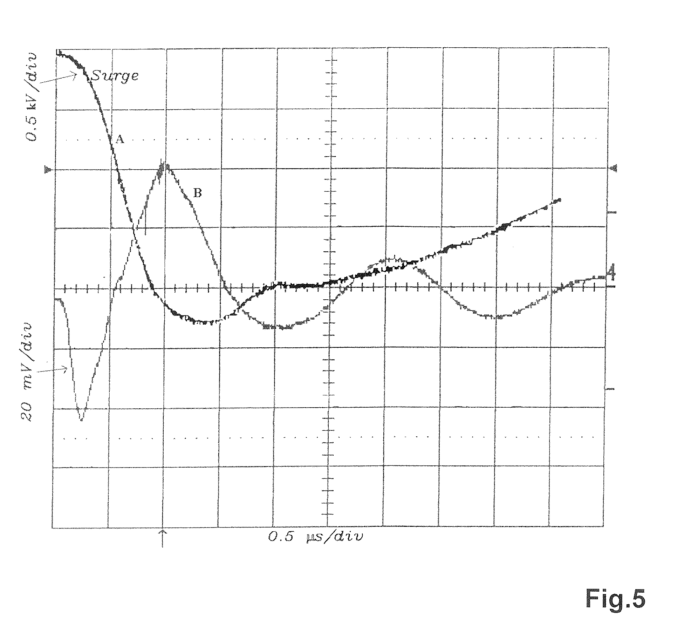

Figure 4 shows a partial discharge signal waveform obtained by an antenna sensor according to the embodiment of figure 1. The antenna sensor has been located close to the first coil of a cross wire stator winding in a random wound electrical motor. In the diagram of figure 4 the following units are shown: X-axis 10 ns/div: Y-axis 20 mV/div. In Fig.4 the partial discharge signal waveform is shown, which has been detected by the antenna sensor, feeding a digital oscilloscope with a sampling rate of 1 GS/s. The proposed sensor antenna is capable of singling out discharges, even during the steep front of the test voltage, if properly designed, as shown in Figure 5.

Figure 5 shows in one diagram the applied impulse test voltage (curve A) together with the signal (curve B) picked up by means of the sensor of figure 1. In the diagram of figure 5 the following units are shown: X-axis 500 ns/div; Y-axis (curve A) 500 V/div, Y-axis (curve B) 20 mV/div. If signal B is considered, it can be clearly remarked a first high frequency signal, superimposed on the relatively low frequency component due to the impulsive feeding. This high frequency signal is related to a discharge event that happened during the rise time of the surge voltage. Afterwards, other discharges can be pointed out. Therefore this technique allows the recognition of the partial discharge inception voltage simply by looking at the surge voltage level corresponding to the first detected discharge signal.

## Claims

1. Method for measuring partial discharges in windings of electrical devices, the method comprising the following steps:

   - Applying voltages having high frequency components to the winding of the electrical device;
   - Detecting partial discharge signals by means of a plurality of tuned VHF and/or UHF electromagnetic sensors being arranged at a plurality of freely chosen positions close to the electrical device to determine the position of the discharge location; or
   - Detecting partial discharge signals by means of one tuned VHF and/or UHF electromagnetic sensors being sequentially arranged at a plurality of freely chosen positions close to the electrical device to determine the position of the discharge location; and
   - Evaluating the detected sensor signals by means of electrical hardware and/or software.

2. Method for measuring partial discharges in windings of electrical devices according to claim 1, the method further comprising that a suitable surge test pulse voltage is applied to the windings of the electrical device.

3. Method for measuring partial discharges in windings of electrical devices according to one of the precedent claims, the method further comprising that the plurality of sensors comprises at least three sensors.

4. Method for measuring partial discharges in windings of electrical devices according to one of the precedent claims, the method further comprising that the applied voltage is a high frequency Ac or a Dc voltage or a frequency converter output.

5. Method for measuring partial discharges in windings of electrical devices according to one of the precedent claims, the method further comprising that a surge test voltage having a variable pulse is applied wherein the repetition rates are different from 50/60 Hz.

6. Method for measuring partial discharges in windings of electrical devices according to one of the precedent claims, the method further comprising that the detected sensor signals are filtered by a conditioning circuit.

7. Method for measuring partial discharges in windings of electrical devices according to one of the claims 1 to 5, the method further comprising that the detected sensor signals are filtered by a software filter, in particular based on the Fast Fourier Transformation (FFT).

8. Method for measuring partial discharges in windings of electrical devices according to one of the precedent claims, the method further comprising that the discharge patterns are quantitatively **characterized by** means of stochastic analysis.

9. Method for measuring partial discharges in windings of electrical devices according to one of the precedent claims, the method further comprising that the sensor is located near the coils connected to the high voltage source.

10. Method for measuring partial discharges in windings of electrical devices according to one of the precedent claims, the method further comprising that at least two high frequency sensors are placed near to the machine's high voltage terminal and to the low voltage terminal respectively, to reject noise and / or to infer the discharge position along the winding by means of a differential measuring mode.

11. Electromagnetic sensor for measuring partial discharges in windings of electrical devices wherein an antenna made of a coaxial cable is provided as VHF and/or UHF electromagnetic sensor, **characterized in that** the sensor is a linear antenna, preferably coupled to the transverse electric and magnetic field.

12. Electromagnetic sensor for measuring partial discharges in windings of electrical devices according to claim 11, wherein the tuned frequency of the antenna is selected according to the signal range of interest, in particular in the GHz range.

13. Electromagnetic sensor for measuring partial discharges in windings of electrical devices according to one of claims 11 or 12, wherein the inner conductor of the coaxial cable is freed in a length of ¼ wavelength corresponding to the tuned frequency to be detected.

14. Electromagnetic sensor for measuring partial discharges in windings of electrical devices according to one of claims 11 to 13, wherein the length of the antenna is 25 mm for a tuned frequency of 3 GHz.

Inner Conductor     Polyetilene Dielectric     Outer Conductor     Sheath

$\lambda_{/4}$

Fig.1

as3_02 txt

Fig.2

Fig.3

Fig.4

Fig.5

**European Patent Office**

**EUROPEAN SEARCH REPORT**

Application Number

EP 03 10 3659

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | DE 299 12 212 U (MUELLER KAI) 21 December 2000 (2000-12-21) * page 1, paragraph 1 - page 4, paragraph 2; figures 1-5 * | 1,11 | G01R31/06 G01R31/34 |
| A | WO 94/07152 A (SIEMENS AG ; GRUENEWALD PETER (DE); WEIDNER JUERGEN (DE); KOZIEL REINH) 31 March 1994 (1994-03-31) * page 4, line 18 - line 31 * * page 10, line 14 - page 11, line 6; figure 3 * | 1,11,13 | |
| A | US 5 252 927 A (BRUEHLMEIER PAUL ET AL) 12 October 1993 (1993-10-12) * column 3, line 14 - column 4, line 5; figure 1 * | 1,11 | |
| A | US 5 164 662 A (EMERY FRANKLIN T ET AL) 17 November 1992 (1992-11-17) * column 2, line 12 - line 26; claim 5; figure 1 * | 1 | |
| A | PATENT ABSTRACTS OF JAPAN vol. 1998, no. 01, 30 January 1998 (1998-01-30) & JP 9 245658 A (NISSIN ELECTRIC CO LTD), 19 September 1997 (1997-09-19) * abstract * | 11 | TECHNICAL FIELDS SEARCHED (Int.Cl.7) G01R |

The present search report has been drawn up for all claims

| Place of search | Date of completion of the search | Examiner |
|---|---|---|
| The Hague | 19 March 2004 | Heinsius, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 03 10 3659

This annex lists the patent family members relating to the patent documents cited in the above-mentioned European search report.
The members are as contained in the European Patent Office EDP file on
The European Patent Office is in no way liable for these particulars which are merely given for the purpose of information.

19-03-2004

| Patent document cited in search report | | Publication date | Patent family member(s) | | Publication date |
|---|---|---|---|---|---|
| DE 29912212 | U | 21-12-2000 | DE | 29912212 U1 | 21-12-2000 |
| WO 9407152 | A | 31-03-1994 | AT | 145482 T | 15-12-1996 |
| | | | CN | 1096104 A ,B | 07-12-1994 |
| | | | CZ | 9500607 A3 | 14-06-1995 |
| | | | WO | 9407152 A1 | 31-03-1994 |
| | | | DE | 59304558 D1 | 02-01-1997 |
| | | | EP | 0662220 A1 | 12-07-1995 |
| | | | ES | 2095664 T3 | 16-02-1997 |
| | | | JP | 8501389 T | 13-02-1996 |
| | | | RU | 2129285 C1 | 20-04-1999 |
| | | | US | 5917334 A | 29-06-1999 |
| US 5252927 | A | 12-10-1993 | EP | 0482229 A1 | 29-04-1992 |
| | | | AT | 109894 T | 15-08-1994 |
| | | | CA | 2053327 A1 | 23-04-1992 |
| | | | DE | 59006789 D1 | 15-09-1994 |
| | | | ES | 2060890 T3 | 01-12-1994 |
| | | | JP | 4273074 A | 29-09-1992 |
| US 5164662 | A | 17-11-1992 | NONE | | |
| JP 9245658 | A | 19-09-1997 | NONE | | |

For more details about this annex : see Official Journal of the European Patent Office, No. 12/82